(19) Europäisches Patentamt
European Patent Office
Office européen des brevets

(11) **EP 1 947 378 A1**

(12) **DEMANDE DE BREVET EUROPEEN**

(43) Date de publication:
**23.07.2008 Bulletin 2008/30**

(51) Int Cl.:
***F21K 7/00*** *(2006.01)*      ***F21V 7/22*** *(2006.01)*
*F21Y 101/02* *(2006.01)*

(21) Numéro de dépôt: **06126388.5**

(22) Date de dépôt: **18.12.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK RS**

(71) Demandeur: **AGC Flat Glass Europe SA**
**1170 Bruxelles (BE)**

(72) Inventeur: **La désignation de l'inventeur n'a pas encore été déposée**

(74) Mandataire: **Decamps, Alain René François et al**
**AGC Flat Glass Europe SA**
**Intellectual Property Department**
**R&D Centre**
**Rue de l'Aurore, 2**
**6040 Jumet (BE)**

(54) **Panneau lumineux à LEDs avec un revêtement électro conducteur et réfléchissant**

(57) Panneau lumineux comprenant un substrat rigide enduit d'un revêtement électro conducteur qui alimente des diodes électroluminescentes (LEDs) et qui comprend une couche dont une des faces réfléchit la lumière visible.

EP 1 947 378 A1

**Description**

La présente invention concerne un panneau lumineux comprenant un substrat rigide et des diodes électroluminescentes (LED's). L'invention s'adresse à un panneau lumineux dont un revêtement comprend une couche réfléchissante.

On connaît un dispositif d'éclairage comprenant un panneau de support transparent en verre revêtu de bandes conductrices de l'électricité sur lesquelles sont montées des diodes électroluminescentes émettant leur lumière au travers du support transparent (brevet US 6,270,236 B1).

Ce dispositif connu ne divulgue toutefois pas de couche réfléchissante.

L'invention a pour but de fournir un panneau lumineux qui est aussi un miroir par ses propriétés de réflexion de la lumière visible.

A cet effet, l'invention concerne un panneau lumineux tel que défini dans la revendication 1.

Les revendications dépendantes définissent d'autres formes possibles de réalisation de l'invention, dont certaines sont préférées.

Le panneau lumineux selon l'invention comprend un substrat rigide. Par substrat rigide on entend ici un corps plein de forme plate, c'est-à-dire de faible épaisseur comparée à ses autres dimensions et de résistance mécanique aux sollicitations de flexion et de torsion suffisante pour ne pas se déformer sous l'action de sollicitations extérieures que l'on rencontre couramment dans le milieu ambiant dans lequel on utilise généralement le panneau. En particulier, les substrats rigides utilisés résistent généralement bien au vent, et aux intempéries en général, que l'on rencontre dans les milieux d'utilisation de ces panneaux, y compris la glace et la neige. Le substrat peut se présenter sous la forme d'une plaque rigide constituée d'un matériau unique ou au contraire être le résultat d'un assemblage de plusieurs feuilles ou plaques du même matériau ou de matériaux différents collés ou soudés les uns aux autres. Des exemples sont des plaques métalliques, des plaques en céramique, en bois, en matière plastique ou en verre. Les matières transparentes aux longueurs d'ondes du spectre de la lumière visible sont préférées. Parmi celles-ci, les verres inorganiques traditionnels sont préférés, en particulier les verres sodo-calciques. De préférence, le substrat comprend au moins une feuille de verre.

Selon l'invention, le substrat rigide est enduit d'un revêtement comprenant une couche qui réfléchit la lumière visible dans la direction et le sens de l'observation par un utilisateur.

Il est avantageux que ce revêtement présente un voile ("haze") de 5 % au plus dans sa portion située du côté de l'observation, c'est-à-dire du côté de l'émission lumineuse des LED's.

Le voile d'un milieu transparent est mesuré en transmission de la lumière et est directement lié à la diffusion de la lumière dans les directions autres que celles du rayonnement lumineux incident. Il a un impact marqué sur la réflexion diffuse de ce milieu lorsque celui-ci est revêtu d'une couche réfléchissante en raison du fait que tout rayon incident sur le panneau traverse deux fois le milieu transparent avant d'atteindre l'oeil de l'observateur. On prend par conséquent souvent la mesure de réflexion diffuse pour une estimation du voile d'un milieu transparent revêtu d'une couche réfléchissante. Un panneau ayant un coefficient de réflexion diffuse $R_{vd}$ de 0,1 à 1,5 % est préféré. Plus préféré encore sont les panneaux présentant une réflexion diffuse $R_{vd}$ de 0,1 à 0,6 %.

On mesure le coefficient de réflexion diffuse avec un spectrophotomètre équipé d'une sphère d'intégration. Un spectrophotomètre de type Perkin-Elmer® 900 a donné d'excellents résultats. La face avant du panneau dont le voile doit être mesuré est appliquée tangentiellement sur la sphère de façon à obturer une petite ouverture de sa surface. Un rayon incident monochromatique délivré par un dispositif monochromateur du spectrophotomètre est dirigé vers l'échantillon à mesurer obturant l'ouverture dans la sphère, selon un angle de faible valeur par rapport à la perpendiculaire à la surface de l'échantillon. Une ouverture opposée dans la sphère située dans la direction de l'angle de faible valeur symétrique de l'autre côté de la perpendiculaire permet la sortie du rayon lumineux réfléchi spéculairement par la surface réfléchissante de l'échantillon, la sphère piégeant tous les rayons lumineux diffus réfléchis dans toute autre direction. Un capteur photoélectrique situé ailleurs sur la surface de la sphère mesure sous un angle d'observation de 10° la lumière monochromatique diffuse totale intégrée par la sphère. Le coefficient de réflexion diffuse $R_{vd}$ est alors calculé comme suit, en intégrant l'ensemble des lumières diffuses monochromatiques sur la totalité de la gamme des longueurs d'onde du spectre visible :

$$R_{vd} = \frac{\sum_{\lambda=380}^{780\text{nm}} R_{vd}(\lambda) * V(\lambda) * D65(\lambda)}{\sum_{\lambda=380}^{780\text{nm}} V(\lambda) * D65(\lambda)}$$

où,

$R_{vd}(\lambda)$ est la lumière diffuse spectrale totale,

$V(\lambda)$ est la sensibilité lumineuse spectrale d'un oeil humain moyen

et $D65(\lambda)$ est la distribution spectrale relative de l'illuminant normalisé "D65".

Il faut noter que dans le cas où le rayon monochromatique incident n'est pas proche de la perpendiculaire à la surface de l'échantillon, comme pour les mesures décrites ci-dessus, mais est au contraire proche de la tangente à cette surface, la réflexion diffuse mesurée dans ces conditions doit aussi rester faible.

Selon l'invention, le revêtement comprend une structure électro conductrice transparente à la lumière visible et située du côté de la face réfléchissante de la couche réfléchissante. Par structure électro conductrice on entend une couche électro conductrice du type pyrolytique ou obtenue par pulvérisation cathodique magnétron sous vide ("magnetron sputtering").

Dans un premier mode de réalisation de l'invention, la couche électro conductrice est une couche pyrolytique déposée sur la surface du verre à des températures allant de 500 à 750 °C. De préférence, la couche pyrolytique conductrice a été déposée à des températures de 570 à 660 °C. Une couche de ce type peut être déposée directement sur le ruban de verre chaud, à la sortie de l'étape dans laquelle le verre fondu flotte à la surface d'un bain d'étain métallique liquide, dans le procédé de fabrication bien connu du verre flotté ("float glass"). Le dépôt peut être fait par pulvérisation (spray) de fines gouttes de liquide ou par dépôt chimique en phase vapeur. Avantageusement, la couche pyrolytique est une couche déposée chimiquement en phase vapeur. Généralement, la nature de cette couche pyrolytique est essentiellement du $SnO_2$ dopé avec du fluor et/ou de l'antimoine. Une couche pyrolytique consistant essentiellement de $SnO_2$ dopé avec du fluor a donné d'excellents résultats. L'épaisseur de cette couche pyrolytique doit être adaptée soigneusement afin de fournir une résistance électrique de surface adéquate. Des épaisseurs de la couche pyrolytique devraient avantageusement se situer de 250 à 500 nm. Une épaisseur d'environ 300 nm a donné d'excellents résultats. La résistance de surface d'une couche conductrice adaptée à l'invention se situe de 1 à 50 $\Omega/\square$. De préférence, cette résistance est de 1 à 15 $\Omega/\square$. Des résistances de surface de 1,5 à 12 $\Omega/\square$ ont donné d'excellents résultats.

Lorsqu'elle est appliquée sur du verre clair (4 mm d'épaisseur), la transmission lumineuse d'une telle couche conductrice pyrolytique n'est généralement pas inférieure à 50 % et, de préférence, pas inférieure à 75 %, la mesure étant faite sous illuminant standardisé D65 par la CIE (Commission Internationale de l'Eclairage) et avec un angle solide de 2°. Des couches fournissant une transmission lumineuse de 76 à 79 % ont donné d'excellents résultats.

Dans ce mode de réalisation, la couche conductrice a une rugosité totale de surface de 20 à 40 nm et, de préférence, de 20 à 30 nm. Par rugosité totale de surface ($R_t$) on entend la somme de la plus grande hauteur des protubérances ($R_{prot}$) et de la plus grande profondeur des puits ($R_{pit}$ mesurée à l'aide d'un microscope à force atomique. Ce dernier délivre des hauteurs individuelles $h_{ij}$ pour chaque point de la surface selon deux directions perpendiculaires i et j. $R_t$ peut être calculé comme suit :

$$R_t = R_{prot} + R_{pit}$$

où :

$$R_{prot} = \left| \max_{i,j}\{h_{ij} - h_{moy}\} \right|$$

$$R_{pit} = \left| \min_{i,j}\{h_{ij} - h_{moy}\} \right|$$

$$h_{moy} = \frac{1}{N} \sum_i \sum_j h_{ij}$$

N étant le nombre total de mesures.

Toute méthode connue peut être utilisée pour réaliser cette rugosité de surface. De bons résultats ont été obtenus avec un verre "float" revêtu d'une couche électro conductrice qui a été polie mécaniquement à l'aide d'abrasifs pendant le temps nécessaire à l'obtention de la rugosité désirée.

Dans un deuxième mode de réalisation de l'invention, la couche électro conductrice est une couche obtenue par pulvérisation cathodique magnétron sous vide ("magnetron sputtering"). Par exemple, la couche peut être une couche tendre constituée d'un empilage des couches élémentaires suivantes :

$$T'O_2 / ZnO / Ag / Ti / ZnO / SnO_2$$

La résistance de surface de ces couches magnétron est généralement de 1 à 20 $\Omega/\square$ et, de préférence de 1 à 10 $\Omega/\square$. Une valeur de résistance de surface de 5 $\Omega/\square$ a donné d'excellents résultats.

Lorsqu'elle est appliquée sur du verre clair (4 mm d'épaisseur), la transmission lumineuse d'une telle couche conductrice n'est généralement pas inférieure à 40 % et, de préférence, pas inférieure à 80 %, la mesure étant faite sous illuminant standardisé D65 par la CIE (Commission Internationale de l'Eclairage) et avec un angle solide de 2°.

La couche conductrice magnétron peut aussi être constituée d'un empilage qui comprend une couche électro conductrice Zn dopé Al ou encore une couche In dopé Sn (couche "ITO"). La résistance de surface de ces couches est d'environ 4 à 50 $\Omega/\square$ et, de préférence d'environ 4 à 15 $\Omega/\square$.

La transmission lumineuse d'une telle couche conductrice appliquée sur du verre clair (4 mm d'épaisseur) n'est généralement pas inférieure à 80 % et, de préférence 84 %, la mesure étant faite sous illuminant standardisé D65 par la CIE (Commission Internationale de l'Eclairage) et avec un angle solide de 2°.

On préfère généralement les couches pyrolytiques aux couches magnétron, en raison de leur résistance mécanique à la rayure plus élevée.

Dans l'un ou l'autre de ces deux modes de réalisation de la couche conductrice, la couche réfléchissante du panneau peut ne réfléchir que partiellement la lumière visible incidente. C'est par exemple le cas d'un miroir dont la couche argentique n'est pas totalement opaque et laisse passer une partie de la lumière. Dans cette variante, une option est de disposer les LED's de manière telle que leur flux lumineux soit dirigé vers la couche réfléchissante partielle afin de pouvoir aisément la traverser. On réalise de cette façon un miroir lumineux qui éclaire en même temps les objets qu'il réfléchit.

Au lieu de réfléchir partiellement la lumière visible incidente, la couche réfléchissante du panneau peut aussi réfléchir totalement la lumière incidente et.

Une autre variante est au contraire le cas d'une couche réfléchissante miroir qui réfléchit totalement la lumière visible incidente. C'est par exemple le cas d'un panneau lumineux d'éclairage dans lequel une couche réfléchissante est découpée et absente sur de petites surfaces au droit de chacune des LED's. C'est aussi le cas d'un panneau dans lequel une couche réfléchissante est située à l'arrière des LED's par rapport à la direction de l'émission du flux lumineux, améliorant ainsi l'intensité du flux par renvoi de la lumière non dirigée dans la direction du flux principal et qui serait perdue en l'absence de cette disposition.

Dans une autre variante encore, la couche conductrice peut être confondue avec la couche réfléchissante.

Dans un des modes de réalisation décrit plus haut, il est avantageux que les connecteurs électriques d'alimentation de chaque LED soient en contact avec la structure électro conductrice. Dans ce mode de réalisation, on préfère que des zones faisant office de pistes d'amenée et d'évacuation du courant électrique aient été isolées du reste de la structure électro conductrice par de fines bandes isolantes découpées dans celle-ci. Ces bandes isolantes ont pu, par exemple être enlevées par l'action d'un rayon laser. Ces bandes isolantes peuvent être quasi invisibles à l'oeil nu. Avantageusement, la largeur d'une bande isolante est inférieure à 150 $\mu$m, de préférence inférieure à 100 $\mu$m. De manière particulièrement préférée, ces bandes ont une largeur inférieure à 50 $\mu$m et de manière la plus préférée, inférieure à 10 $\mu$m.

**Revendications**

1. Panneau lumineux comprenant un substrat rigide enduit d'un revêtement électro conducteur qui alimente des diodes électroluminescentes (LEDs), **caractérisé en ce que** le revêtement comprend une couche dont une des faces réfléchit la lumière visible.

2. Panneau lumineux selon la revendication 1, **caractérisé en ce que** le revêtement présente un voile en transmission de 5 % au plus dans sa portion située du côté de la face réfléchissante de la couche réfléchissante.

3. Panneau lumineux selon la revendication précédente, **caractérisé en ce que** le revêtement comprend une structure électro conductrice transparente à la lumière visible et située du côté de la face réfléchissante de la couche réfléchissante.

4. Panneau lumineux selon la revendication 2, **caractérisé en ce que** le revêtement comprend une structure électro conductrice transparente à la lumière visible et située du côté opposé à la face réfléchissante de la couche réfléchissante.

5. Panneau lumineux selon une quelconque des revendications 2 à 4, **caractérisé en ce que** la structure électro conductrice est du type pyrolytique ou magnétron sous vide.

6. Panneau lumineux selon la revendication précédente, **caractérisé en ce que** la structure électro conductrice est du type pyrolytique déposé par spray de liquide ou par la technique CVD.

7. Panneau lumineux selon la revendication précédente, **caractérisé en ce que** le revêtement présente une rugosité de surface de 20 à 40 nm.

8. Panneau lumineux selon la revendication 5, **caractérisé en ce que** la structure électro conductrice est obtenue par pulvérisation cathodique magnétron sous vide ("magnetron sputtering").

9. Panneau lumineux selon une quelconque des revendications précédentes, **caractérisé en ce que** la transmission lumineuse de la structure électro conductrice est d'au moins 84 % lorsqu'elle est appliquée sur un verre clair de 4 mm d'épaisseur, la mesure étant faite sous illuminant normalisé D65, avec un angle solide de 2 degrés.

10. Panneau lumineux selon une quelconque des revendications 2 à 9, **caractérisé en ce que** la couche réfléchissante ne réfléchit que partiellement la lumière visible incidente.

11. Panneau lumineux selon la revendication précédente, **caractérisé en ce que** les LED's sont disposées de manière telle que leur flux lumineux traverse la couche réfléchissante partielle.

12. Panneau lumineux selon une quelconque des revendications 2 à 9, **caractérisé en ce que** la couche réfléchissante est une couche miroir qui réfléchit totalement la lumière visible.

13. Panneau lumineux selon une quelconque des revendications précédentes, **caractérisé en ce que** le substrat comprend au moins une feuille de verre.

14. Panneau lumineux selon une quelconque des revendications 3 à 9, **caractérisé en ce que** les connecteurs électriques d'alimentation des LEDs sont en contact avec la structure électro conductrice.

15. Panneau lumineux selon une quelconque des revendications précédentes, **caractérisé en ce que** des zones faisant office de pistes d'amenée et d'évacuation du courant électrique ont été isolées du reste de la structure électro conductrice par de fines bandes isolantes découpées dans celle-ci.

16. Panneau lumineux selon une quelconque des revendications précédentes, **caractérisé en ce que** le revêtement électro conducteur présente une résistance de surface de 1 à 15 i2/o.

**Office européen des brevets**

**RAPPORT DE RECHERCHE EUROPEENNE**

Numéro de la demande

EP 06 12 6388

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2005/097551 A (PILKINGTON PLC [GB]; BARTON NEIL [GB]; DAY STEPHEN ROLAND [GB]) 20 octobre 2005 (2005-10-20) | 1-4, 12-15 | INV. F21K7/00 F21V7/22 |
| Y | * page 13; figure 7 * | 5,6,8,16 | |
| | ----- | | ADD. F21Y101/02 |
| X | US 5 788 357 A (MUTH MICHAEL D [US] ET AL) 4 août 1998 (1998-08-04) * colonne 5, ligne 28; figure 5 * | 1,2,10, 11 | |
| | ----- | | |
| X | EP 1 535 885 A (GLAVERBEL [BE]) 1 juin 2005 (2005-06-01) | 1 | |
| Y | * alinéas [0009] - [0012] * | 5,6,8,16 | |
| | ----- | | |
| A | US 5 745 291 A (JENKINSON TIMOTHY [GB]) 28 avril 1998 (1998-04-28) * le document en entier * | 1 | |
| | ----- | | |
| A | WO 96/14222 A (UNITED TECHNOLOGIES AUTOMOTIVE [US]) 17 mai 1996 (1996-05-17) * le document en entier * | 1 | |
| | ----- | | DOMAINES TECHNIQUES RECHERCHES (IPC) |
| A | GB 2 326 489 A (GLAVERBEL [BE]) 23 décembre 1998 (1998-12-23) * le document en entier * | 1 | F21V F21K |
| | ----- | | |

Le présent rapport a été établi pour toutes les revendications

| Lieu de la recherche | Date d'achèvement de la recherche | Examinateur |
|---|---|---|
| Munich | 23 avril 2007 | Chao, Oscar |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 06 12 6388

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-04-2007

| Document brevet cité au rapport de recherche | | Date de publication | Membre(s) de la famille de brevet(s) | | Date de publication |
|---|---|---|---|---|---|
| WO 2005097551 | A | 20-10-2005 | EP | 1740413 A1 | 10-01-2007 |
| US 5788357 | A | 04-08-1998 | WO | 9920486 A1 | 29-04-1999 |
| EP 1535885 | A | 01-06-2005 | AUCUN | | |
| US 5745291 | A | 28-04-1998 | AUCUN | | |
| WO 9614222 | A | 17-05-1996 | DE | 69509784 D1 | 24-06-1999 |
| | | | DE | 69509784 T2 | 21-10-1999 |
| | | | EP | 0789653 A1 | 20-08-1997 |
| | | | JP | 10508559 T | 25-08-1998 |
| | | | US | 5587699 A | 24-12-1996 |
| GB 2326489 | A | 23-12-1998 | CA | 2232649 A1 | 25-09-1998 |
| | | | US | 6064525 A | 16-05-2000 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- US 6270236 B1